# EUROPÄISCHE PATENTSCHRIFT

(11) **EP 2 587 512 B1**
(45) Veröffentlichungstag und Bekanntmachung des Hinweises auf die Patenterteilung: **22.03.2017**
(21) Anmeldenummer: 12187906.8
(22) Anmeldetag: 10.10.2012
(51) Int. Cl.: H01H 47/00, G01R 31/327

(54) **Sicherheitsgerichtetes Schaltgerät**
Safety-oriented switching device
Commutateur orienté vers la sécurité

(30) Priorität: 31.10.2011 DE 102011054968
(43) Veröffentlichungstag der Anmeldung: 01.05.2013
(73) Patentinhaber: PHOENIX CONTACT GmbH & Co. KG, 32825 Blomberg (DE)
(72) Erfinder: Peter, Henry, 37574 Einbeck (DE); Eilers, Markus, 31812 Bad Pyrmont (DE); Rohs, Markus, 32825 Blomberg (DE)
(74) Vertreter: Michalski Hüttermann & Partner Patentanwälte mbB

(56) Entgegenhaltungen:
- EP-A2- 1 462 768
- WO-A1-2011/098282
- WO-A2-2006/102316
- US-A1- 2010 123 987

## Beschreibung

Die Erfindung betrifft ein sicherheitsgerichtetes Schaltgerät, mit einem ersten zwangsgeführten Relais, einer Energieversorgung und einem Ausgang zum Melden des Schaltzustands des sicherheitsgerichteten Schaltgeräts.

Sicherheitsrelais haben in verschiedenen Anwendungsgebieten, wie in der Überwachung der Sicherheit an elektrischen Einrichtungen, eine große Bedeutung und dienen insbesondere zur Überwachung der an den Maschinen und Anlagen vorgesehenen Sicherheitseinrichtungen zur schnellen und zuverlässigen Abschaltung der elektrischen Einrichtung im Notfall.

Aus dem Stand der Technik sind eine Vielzahl verschiedener Sicherheitsrelais bekannt, wie beispielsweise ein- und zweikanalige Ausführungen zum Aufbau sicherheitsgerichteter Applikationen. Dabei überwacht eine interne Logik der Sicherheitsrelais die durch die Sicherheitseinrichtungen gebildeten Sicherheitskreise, wie beispielsweise Nothalt, Schutztür, Lichtschranken, Zweihandschaltung etc., und aktiviert im fehlerfreien Zustand die sogenannten Freigabepfade, so dass also das Sicherheitsrelais die mit dem Sicherheitsrelais verbundene elektrische Einrichtung, beispielsweise eine Maschine oder eine Anlage, einschalten kann. Dazu sind die Sicherheitsrelais oftmals entsprechend der gängigen Normen, wie beispielsweise der DIN ISO 13849-1, ausgeführt.

Sicherheitsgerichtete Schaltgeräte, deren Sicherheitsrelais mit Zwangsführung ausgerüstet sind, d.h. ein elektromechanisches Schaltelement aufweisen, das typischerweise mehrere Schließerkontakte und zumindest einen Öffnerkontakt besitzt, wobei der Öffnerkontakt und die Schließerkontakte über eine mechanische Zwangsführung so miteinander gekoppelt sind, dass der Öffnerkontakt und die Schließerkontakte nicht gleichzeitig geschlossen sein können, nutzten vielfach den Öffnerkontakt dieser zwangsgeführten Kontakte zur geräteinternen Diagnose.

Soll nun zusätzlich ein Meldeausgang oder ein Diagnosepfad bereitgestellt werden, so wird von jedem zwangsgeführten Relais ein weiterer Öffnerkontakt benötigt, welcher dann, durch entsprechende Verschaltung, entweder den Anzug aller verbundenen Relais, über den Meldeausgang und parallel geschalteten Öffnerkontakten, oder das Abfallen aller Relais, über den Diagnosepfad und seriell geschalteter Öffnerkontakte, meldet. Allerdings benötigt die Verwendung von zwei Öffner- bzw. Relaiskontakten für die geräteinterne Diagnose und den Melde- bzw. Diagnosepfad nicht nur weitaus mehr Platz, sondern ist auch kostenintensiver in der Herstellung des Relais.

In diesem Zusammenhang ist aus der WO 2006/102316 A2 ein elektrisches Diagnosesystem bekannt, mit dem der Schaltzustand eines zwangsgeführten Relais überwachbar ist. Das zwangsgeführte Relais weist einen Schaltkontakt zum Schalten einer elektrischen Einrichtung auf, der in Serie zwischen einer Energieversorgung und einem Ausgang geschaltet ist. Der Schaltkontakt ist derart zur Überwachung des Schaltzustands des zwangsgeführten Relais ausgestaltet, dass der durch den Schaltkontakt überwachte Schaltzustand auf den Ausgang ausgegeben wird.

Weiter ist aus der US 2010/0123987 A1 ein Sicherheitssystem mit zwei zwangsgeführten Relais, die jeweils einen Schaltkontakt zum Schalten einer elektrischen Einrichtung aufweisen, bekannt. Die Schaltkontakte sind jeweils in Serie zwischen einer Energieversorgung und einem Ausgang geschaltet.

Daher ist es die Aufgabe der Erfindung, ein sicherheitsgerichtetes Schaltgerät mit einem zwangsgeführten Relais anzugeben, das bei beengten Platzverhältnissen und in kostengünstiger Weise sowohl einen Meldeausgang zum Signalisieren des Anzugs des Relais als auch einen Diagnosepfad zum Melden des Abfallen des Relais, insbesondere einer Mehrzahl von Relais, bereitstellt.

Die Lösung der Aufgabe erfolgt durch die Merkmale der unabhängigen Ansprüche. Vorteilhafte Ausgestaltungen der Erfindung sind in den Unteransprüchen angegeben.

Eine Lösung der zuvor genannten Aufgabe erfolgt durch ein sicherheitsgerichtetes Schaltgerät, mit einem ersten zwangsgeführten Relais, einer Energieversorgung und einem Ausgang zum Ausgeben des Schaltzustands des zwangsgeführten Relais, wobei das erste zwangsgeführte Relais einen Schaltkontakt zum Schalten einer elektrischen Einrichtung aufweist, das erste zwangsgeführte Relais zudem einen derart ausgestalteten Öffnerkontakt zum Überwachen des Schaltzustands des ersten zwangsgeführten Relais aufweist, so dass der durch den Öffnerkontakt überwachte Schaltzustand auf den Ausgang ausgegeben wird, der Öffnerkontakt des ersten zwangsgeführten Relais in Serie zwischen der Energieversorgung und den Ausgang sowohl als Meldeausgang als auch als Diagnoseausgang ausgestaltet ist.

Ein wesentlicher Punkt der Erfindung ist somit, dass bei einem gemeinsamen Öffnerkontakt sowohl ein Meldepfad als auch ein Diagnosepfad über den gemeinsamen Ausgang bereitgestellt wird. Das bedeutet also, dass durch die Verwendung eines einzigen Öffnerkontaktes für beide vorgenannten Funktionen gegenüber den aus dem Stand der Technik ausgestalteten Relais ein Relaiskontakt, nämlich ein Öffnerkontakt, eingespart werden kann, da im Stand der Technik sowohl für den Meldepfad als auch für den Diagnosepfad jeweils ein eigener, separater Relaiskontakt, wie ein Öffnerkontakt, benötigt wurde. Vorzugsweise ist das Relais nach DIN EN ISO 13849 ausgeführt, und der Diagnosepfad ist nach DIN EN ISO 13849 für Kategorie 2, Kategorie 3 und/oder Kategorie 4 ausgeführt.

Das sicherheitsgerichtete Schaltgerät bzw. das zwangsgeführte Relais gemäß der Erfindung benötigt daher aufgrund des eingesparten Öffnerkontaktes weniger Platz, was sich insbesondere bei in Schaltschränken üblichen hohen Packungsdichten in einer Kostenersparnis auswirkt. Zum anderen ist das Relais aufgrund der Einsparung eines Kontaktes kostengünstiger im Vergleich zu aus dem Stand der Technik bekannten Relais herstellbar. Zudem lässt sich durch die Abbildung sowohl des Meldepfades als auch des Diagnosepfades über einen einzigen gemeinsamen Ausgang der Verdrahtungsaufwand reduzieren.

Hinsichtlich seiner darüber hinausgehenden Funktionalität kann das zwangsgeführte Relais wie ein aus dem Stand der Technik bekanntes Relais mit mechanischer Zwangsführung ausgeführt sein, also beispielsweise der Öffnerkontakt und die weiteren Kontakte, der Schaltkontakt und/oder ein Schließerkontakt, so miteinander gekoppelt sein, dass der Öffnerkontakt und der Schließerkontakt nicht gleichzeitig geschlossen sein können. Das bedeutet also, dass bei einer Anordnung mit einer Mehrzahl von zwangsgeführten Relais bereits ein Meldeausgang und ein Diagnosepfad gemäß DIN EN ISO 13849 Kategorie 2, Kategorie 3 und/oder Kategorie 4 realisiert werden kann, wenn der Öffnerkontakt, verbunden mit der Energieversorgung, an dem Ausgang sowohl den Anzug aller Relais im Sinne eines Meldeausgangs bei parallel geschalteten Öffnerkontakten als auch das Abfallen aller Relais im Sinne eines Diagnosepfades bei seriell geschalteten Öffnerkontakten signalisieren kann. Dabei kann zusätzlich im Rahmen einer internen Diagnose der Schaltzustand jedes einzelnen Öffnerkontaktes zusätzlich hinter dem jeweiligen Öffnerkontakt ausgelesen werden.

Die Aufgabe der Erfindung ist weiterhin gelöst durch ein sicherheitsgerichtetes Schaltgerät, mit einem ersten zwangsgeführten Relais, einer Energieversorgung und einem Ausgang, wobei das erste zwangsgeführte Relais einen Schaltkontakt zum Schalten einer elektrischen Einrichtung aufweist, das erste zwangsgeführte Relais einen derart ausgestalteten Öffnerkontakt zum Überwachen des Schaltzustands des ersten zwangsgeführten Relais aufweist, so dass der durch den Öffnerkontakt überwachte Schaltzustand auf dem Ausgang sowohl als Meldepfad als auch als Diagnosepfad gemäß DIN EN ISO 13849 für Kategorie 2, Kategorie 3 und/oder Kategorie 4 ausgegeben wird, und der Öffnerkontakt des ersten zwangsgeführten Relais in Serie zwischen der Energieversorgung und dem Ausgang geschaltet ist.

Vorgenannte Norm DIN EN ISO 13849 fordert für Kategorie 2, Kategorie 3 und/oder Kategorie 4, dass an dem sicherheitsgerichteten Schaltgerät eine Diagnose stattfinden muss, wie beispielsweise eine Diagnose der Relaiskontakte mit einem Mikrocontroller, oder ein Ausgang bereitgestellt werden muss, der eine externe Diagnose durch eine übergeordnete Steuerung zulässt, beispielsweise bei in Reihe verschalteten Öffnerkontakten. Aufgrund der Zwangsführung sind durch den Öffnerkontakt ebenfalls die Schaltpositionen der Schließerkontakte signalisierbar, so dass die Steuerung beispielsweise erkennen kann, wenn ein Schließerkontakt verschweißt ist und in seiner geschlossenen, oder geöffneten, Schaltstellung hängen bleibt.

Ein Test einer derartigen Sicherheitsfunktion, also das Rücklesen des Ausgangs zur Überwachung des Schaltzustands des zwangsgeführten Relais, muss gemäß vorgenannter Norm zum einen beim Anlauf der elektrischen Einrichtung sowie zum anderen vor dem Einleiten einer Gefährdungssituation, beispielsweise einem Start eines neuen Zyklus, Start anderer Bewegungen und/oder periodisch während des Betriebes der elektrischen Einrichtungen erfolgen, wenn eine Risikobeurteilung und Betriebsart zeigen, dass dies notwendig ist.

Dabei kann die Einleitung dieses Tests automatisch erfolgen, wobei der Test der Sicherheitsfunktionen entweder den Betrieb der elektrischen Einrichtung zulassen muss, wenn keine Fehler erkannt wurden, oder die Einleitung geeigneter Steuerungsmaßnahmen erzeugen, wenn ein Fehler beim Test erkannt wurde. Sofern ein Fehler erkannt wurde, soll, wenn immer möglich, ein sicherer Zustand der elektrischen Einrichtung eingeleitet werden. Dieser sichere Zustand muss aufrechterhalten bleiben, bis der Fehler behoben ist. Sofern die Einleitung des sicheren Zustandes nicht möglich ist, beispielsweise wenn ein Kontakt des Relais verschweißt ist, muss eine Warnung vor der Gefährdung bereitgestellt werden.

Nach einer bevorzugten Ausführungsform der Erfindung weist das sicherheitsgerichtete Schaltgerät eine erste Diode auf, wobei der Öffnerkontakt des ersten zwangsgeführten Relais und die erste Diode derart in Serie zwischen der Energieversorgung und dem Ausgang geschaltet sind, dass die Kathode der ersten Diode mit dem Ausgang verbunden ist. Weiter ist bevorzugt, dass das sicherheitsgerichtete Schaltgerät ein zweites zwangsgeführtes Relais aufweist, wobei der Öffnerkontakt des ersten zwangsgeführten Relais und der Öffnerkontakt des zweiten zwangsgeführten Relais in Serie zwischen der Energieversorgung und dem Ausgang geschaltet sind. Dadurch können gegenüber dem Stand der Technik wenigstens zwei Öffnerkontakte an dem Relais sowie eine Klemmstelle an dem Schaltgerät eingespart werden. In diesem Zusammenhang ist weiterhin bevorzugt, dass das sicherheitsgerichtete Schaltgerät eine erste weitere Diode aufweist, wobei die erste weitere Diode derart in Serie zwischen dem Öffnerkontakt des ersten zwangsgeführten Relais und der ersten Diode geschaltet ist, dass die Anode der ersten Diode mit der Kathode der ersten weiteren Diode verbunden ist.

Nach einer anderen bevorzugten Ausführungsform sind ein zweites zwangsgeführtes Relais und eine zweite Diode vorgesehen, wobei der Öffnerkontakt des zweiten zwangsgeführten Relais und die zweite Diode derart in Serie zwischen der Energieversorgung und dem Ausgang geschaltet sind, dass die Kathode der zweiten Diode mit dem Ausgang verbunden ist. Durch eine derartige Ausgestaltung erfolgt eine logische Oder-Verknüpfung der Öffnerkontakte der beiden Relais durch die Dioden, wobei hinter den Dioden der Ausgang, beispielsweise zur Zurücklesung des Meldepfades, verschaltet ist. Gegenüber dem Stand der Technik lassen sich dadurch wenigstens zwei Öffnerkontakte der Relais sowie drei Klemmstellen des Schaltgerätes einsparen.

In diesem Zusammenhang ist weiterhin bevorzugt, dass das Schaltgerät eine zweite weitere Diode aufweist, wobei die zweite weitere Diode derart in Serie zwischen dem Öffnerkontakt des zweiten zwangsgeführten Relais und der zweiten Diode geschaltet ist, dass die Anode der zweiten Diode mit der Kathode der zweiten weiteren Diode verbunden ist. Vorzugsweise sind sowohl zwischen dem Öffnerkontakt des ersten zwangsgeführten Relais als auch zwischen dem Öffnerkontakt des zweiten zwangsgeführten Relais und dem Ausgang jeweils zwei Dioden vorgesehen, was zu einer verbesserten Sicherheit aufgrund der redundanten Ausführung der Dioden führt, wobei jeweils die Anode der einen Diode mit der Kathode der anderen Diode, bezogen auf ein jeweiliges Relais, verbunden ist.

Grundsätzlich kann das zwangsgeführte Relais eine beliebige Anzahl von Öffnerkontakten aufweisen, wobei aufgrund der Ausgestaltung, dass durch einen Öffnerkontakt sowohl ein Meldeausgang als auch ein Diagnoseausgang bereitgestellt wird, die über den Ausgang gewonnene Rückmeldung des Schaltzustands eine sicherheitsgerichtete Meldung gemäß vorgenannter Normen darstellt. Da also zur Erreichung dieses erfindungsgemäßen Vorteils nur ein einziger Öffnerkontakt an dem durch den Ausgang überwachten Relais vorhanden sein muss, gilt gemäß einer weiteren Ausführungsform der Erfindung, dass das zwangsgeführte Relais auch nur einen einzigen Öffnerkontakt aufweist.

Insbesondere bei einer Anordnung mit einer Mehrzahl von Relais kann über den Ausgang, wie bereits ausgeführt, sowohl der Meldepfad als auch der Diagnosepfad vorgenannter Norm realisiert werden. Zusätzlich ist gemäß einer weiteren Ausführungsform der Erfindung bevorzugt, dass das sicherheitsgerichtete Schaltgerät einen Mikrocontroller zum Überwachen des Schaltzustands des zwangsgeführten Relais aufweist, wobei der Mikrocontroller mit dem Öffnerkontakt des zwangsgeführten Relais verbunden ist. Dadurch lässt sich eine Diagnose, eine sogenannte interne Diagnose, jedes einzelnen Relaiskontaktes bewerkstelligen.

In diesem Zusammenhang ist weiterhin bevorzugt, dass ein galvanisches Trennelement vorgesehen ist, wobei das galvanische Trennelement zwischen dem Mikrocontroller und dem Öffnerkontakt des zwangsgeführten Relais angeordnet ist. Weiterhin ist bevorzugt, dass jedem zwangsgeführten Relais jeweils ein Mikrocontroller zugeordnet ist. Dadurch kann dediziert jeder einzelne Relaiskontakt durch einen jeweiligen Mikrocontroller überwacht werden.

Die Aufgabe der Erfindung wird weiterhin gelöst durch ein sicherheitsgerichtetes Schaltgerät, mit einem ersten zwangsgeführten Relais, einer Energieversorgung, einer ersten Diode und einem Meldeausgang, wobei das erste zwangsgeführte Relais einen Schaltkontakt zum Schalten einer elektrischen Einrichtung aufweist, das erste zwangsgeführte Relais einen derart ausgestalteten Öffnerkontakt zum Überwachen des Schaltzustands des ersten zwangsgeführten Relais aufweist, so dass der durch den Öffnerkontakt überwachte Schaltzustand auf den Ausgang ausgegeben wird, und der Öffnerkontakt des ersten zwangsgeführten Relais und die erste Diode derart in Serie zwischen der Energieversorgung und dem Meldeausgang geschaltet sind, dass die Kathode der ersten Diode mit dem Meldeausgang verbunden ist.

Weitere Ausführungsformen und Vorteile des Schaltgeräts ergeben sich dem Fachmann in Analogie zu dem eingangs beschriebenen Schaltgerät.

Nachfolgend wird die Erfindung unter Bezugnahme auf die anliegende Zeichnung anhand bevorzugter Ausführungsformen näher erläutert.

Es zeigen
- Fig. 1: ein sicherheitsgerichtetes Schaltgerät gemäß einer ersten Ausführungsform der Erfindung,
- Fig. 2: ein sicherheitsgerichtetes Schaltgerät gemäß einer weiteren Ausführungsform der Erfindung,
- Fig. 3: ein sicherheitsgerichtetes Schaltgerät gemäß einer weiteren Ausführungsform der Erfindung,
- Fig. 4: ein sicherheitsgerichtetes Schaltgerät gemäß einer weiteren Ausführungsform der Erfindung,
- Fig. 5: ein sicherheitsgerichtetes Schaltgerät gemäß einer weiteren Ausführungsform der Erfindung, und
- Fig. 6: ein sicherheitsgerichtetes Schaltgerät gemäß einer weiteren Ausführungsform der Erfindung.

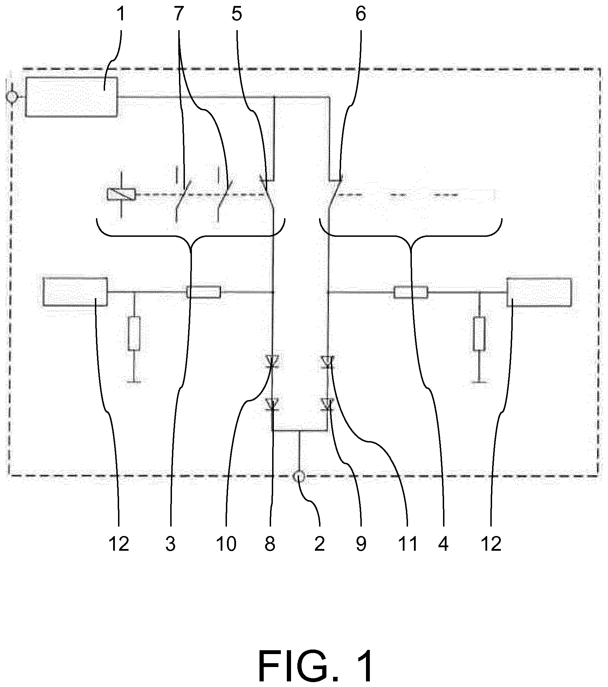

Die Figuren 1 bis 6 zeigen jeweils ein sicherheitsgerichtetes Schaltgerät gemäß einer jeweils anderen bevorzugten Ausführungsform der Erfindung. Dabei ist jeweils eine Energieversorgung 1 vorgesehen, die als Spannungsversorgung ausgestaltet ist.

Zwischen der Energieversorgung 1 und einem Ausgang 2 ist wenigstens ein zwangsgeführtes Relais 3, 4 vorgesehen, nämlich in Fig. 1 zwei zwangsgeführte Relais 3, 4, ein erstes zwangsgeführtes Relais 3 sowie ein zweites zwangsgeführtes Relais 4, die jeweils einen Öffnerkontakt 5, 6 aufweisen und hinsichtlich ihrer Öffnerkontakte 5, 6 parallel geschaltet sind.

Jedes der beiden zwangsgeführten Relais 3, 4 weist zudem eine Mehrzahl von Schaltkontakten 7 zum Schalten einer elektrischen Einrichtung, nicht gezeigt, auf. Mittels einer ersten und zweiten Dioden 8, 9, sowie zu den ersten und zweiten Dioden 8, 9 in Serie geschalteten ersten und zweiten weiteren Dioden 10, 11, sind durch die vorliegende Ausgestaltung die beiden Öffnerkontakte 5, 6 ODERverknüpft, so dass an dem Ausgang 2 der Schaltzustand der Relais 3, 4 ausgegeben wird.

Dabei ist gemäß der Erfindung, also aufgrund der Verwendung nur eines einzigen Öffnerkontaktes 5, 6 an jedem der beiden Relais 3, 4, der Ausgang 2 sowohl als Meldeausgang und auch als Diagnoseausgang gemäß DIN EN ISO 13849 für Kategorie 2, Kategorie 3 und Kategorie 4 ausgestaltet. Das bedeutet, dass, gegenüber dem Stand der Technik, bereits durch einen einzigen Öffnerkontakt 5, 6 der Schaltzustand des Relais 3, 4 über den Ausgang 2 als Meldeausgang und als Diagnoseausgang auslesbar ist.

Wie zudem aus Fig. 1 ersichtlich, ist jedem Relais 3, 4 ein Mikrocontroller 12 zugeordnet, so dass hinter dem jeweiligen Öffnerkontakt 5, 6 eine interne Diagnose des Öffnerkontaktes 5, 6 durch den Mikrocontroller 12 durchführbar ist.

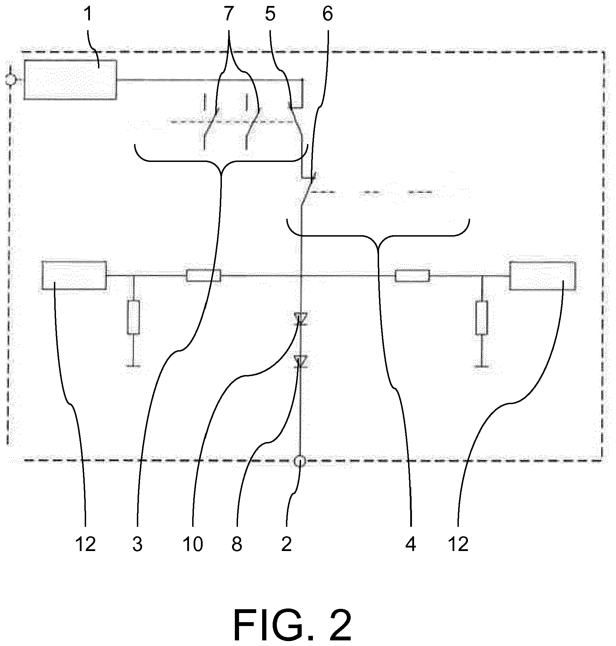

Fig. 2 zeigt die Serienschaltung zweier Öffnerkontakte 5, 6 zweier Relais 3, 4 zwischen der Energieversorgung 1 und dem Ausgang 2, wobei ebenfalls zwei Mikrocontroller 12 zur internen Diagnose vorgesehen sind.

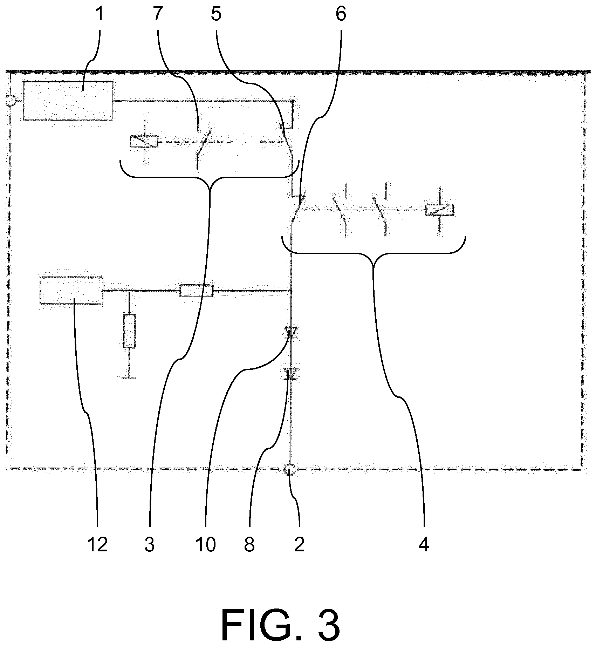

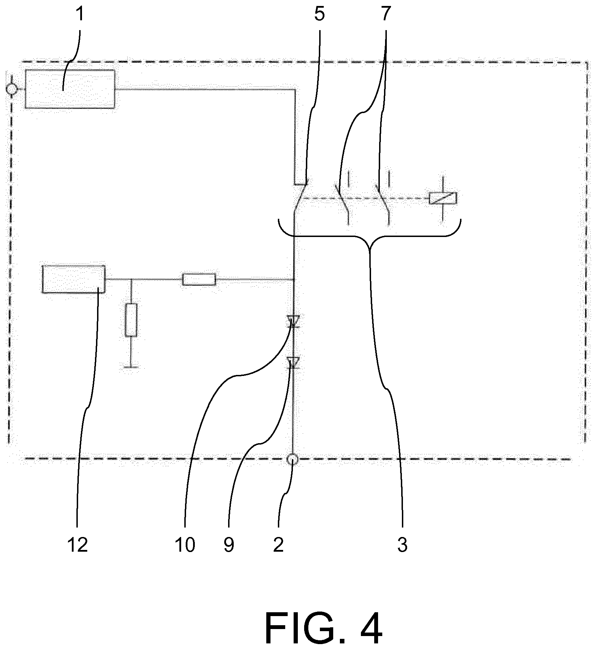

Aus Fig. 3 ist eine vergleichbare Schaltung ersichtlich, allerdings nur mit einem einzigen Mikrocontroller 12. Fig. 4 zeigt ein einziges Relais 5, wobei ebenfalls ein Mikrocontroller 12 zwischen dem Öffnerkontakt 5 und dem Ausgang 2 vorgesehen ist.

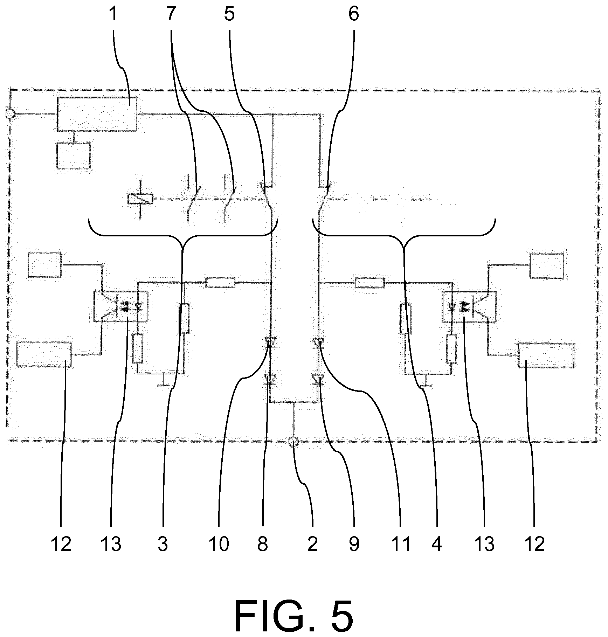

Fig. 5 zeigt dagegen einen gegenüber Fig. 1 erweiterten Schaltungsaufbau, nämlich jeweils ein galvanisches Trennelement 13, welches zwischen dem Mikrocontroller 12 und dem Öffnerkontakt 5, 6 vorgesehen ist.

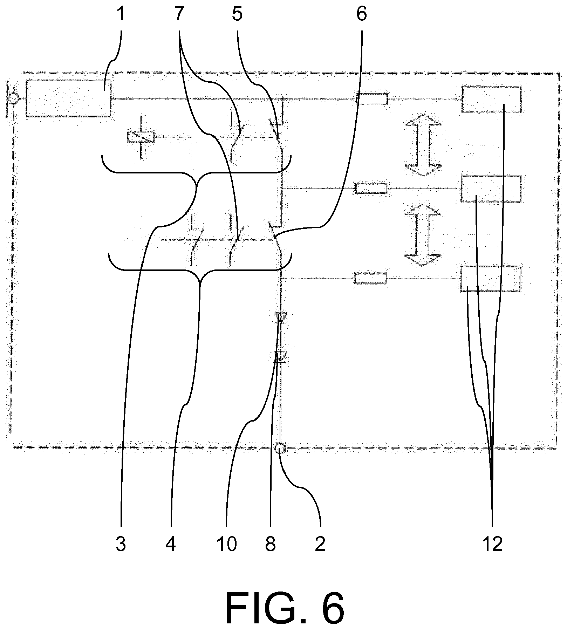

Schließlich zeigt Fig. 6 eine Fortbildung der in Fig. 2 gezeigten Schaltungsanordnung, wobei in Fig. 6 jedoch an jedem Öffnerkontakt 5, 6 ein Mikrocontroller 12 zur gegenseitigen Diagnose bzw. Prüfung, welcher Öffnerkontakt 5, 6 geschlossen bzw. geöffnet ist, vorgesehen ist.

### Bezugszeichenliste

- Energieversorgung: 1
- Ausgang: 2
- Erstes Relais: 3
- Zweites Relais: 4
- Öffnerkontakt: 5
- Öffnerkontakt: 6
- Schaltkontakt: 7
- Erste Diode: 8
- Zweite Diode: 9
- Erste weitere Diode: 10
- Zweite weitere Diode: 11
- Mikrocontroller: 12
- Galvanisches Trennelement: 13

## Patentansprüche

1. Sicherheitsgerichtetes Schaltgerät, mit einem ersten zwangsgeführten Relais (3), einer Energieversorgung (1) und einem Ausgang (2), wobei
das erste zwangsgeführte Relais (3) einen Schaltkontakt (7) zum Schalten einer elektrischen Einrichtung aufweist,
**dadurch gekennzeichnet, dass**
das erste zwangsgeführte Relais (3) zudem einen derart ausgestalteten Öffnerkontakt (5) zum Überwachen des Schaltzustands des ersten zwangsgeführten Relais (3) aufweist, so dass der durch den Öffnerkontakt (5) überwachte Schaltzustand auf den Ausgang (2) ausgegeben wird,
der Öffnerkontakt (5) des ersten zwangsgeführten Relais (3) in Serie zwischen der Energieversorgung (1) und dem Ausgang (2) geschaltet ist, und
der Ausgang (2) als Meldeausgang und als Diagnoseausgang ausgestaltet ist.

2. Sicherheitsgerichtetes Schaltgerät nach dem vorhergehenden Anspruch, mit einer ersten Diode (8), wobei der Öffnerkontakt (5) des ersten zwangsgeführten Relais (3) und die erste Diode (8) derart in Serie zwischen der Energieversorgung (1) und dem Ausgang (2) geschaltet sind, dass die Kathode der ersten Diode (8) mit dem Ausgang (2) verbunden ist.

3. Sicherheitsgerichtetes Schaltgerät nach einem der vorhergehenden Ansprüche, mit einem zweiten zwangsgeführten Relais (4), wobei der Öffnerkontakt (5) des ersten zwangsgeführten Relais (3) und der Öffnerkontakt (4) des zweiten zwangsgeführten Relais (4) in Serie zwischen der Energieversorgung (1) und dem Ausgang (2) geschaltet sind.

4. Sicherheitsgerichtetes Schaltgerät nach einem der Ansprüche 2 oder 3, mit einer ersten weiteren Diode(10), wobei die erste weitere Diode (10) derart in Serie zwischen dem Öffnerkontakt (5) des ersten zwangsgeführten Relais (3) und der ersten Diode (8) geschaltet ist, dass die Anode der ersten Diode (8) mit der Kathode der ersten weiteren Diode (10) verbunden ist.

5. Sicherheitsgerichtetes Schaltgerät nach Anspruch 2, mit einem zweiten zwangsgeführten Relais (4) und einer zweiten Diode (9), wobei der Öffnerkontakt (6) des zweiten zwangsgeführten Relais (4) und die zweite Diode (9) derart in Serie zwischen der Energieversorgung (1) und dem Ausgang (2) geschaltet sind, dass die Kathode der zweiten Diode (9) mit dem Ausgang (2) verbunden ist.

6. Sicherheitsgerichtetes Schaltgerät nach Anspruch 5, mit einer zweiten weiteren Diode (11), wobei die zweite weitere Diode (11) derart in Serie zwischen dem Öffnerkontakt (6) des zweiten zwangsgeführten Relais (4) und der zweiten Diode (9) geschaltet ist, dass die Anode der zweiten Diode (9) mit der Kathode der zweiten weiteren Diode (11) verbunden ist.

7. Sicherheitsgerichtetes Schaltgerät nach einem der vorhergehenden Ansprüche, wobei das zwangsgeführte Relais (3, 4) nur einen einzigen Öffnerkontakt (5, 6) aufweist.

8. Sicherheitsgerichtetes Schaltgerät nach einem der vorhergehenden Ansprüche, mit einem Mikrocontroller (12) zum Überwachen des Schaltzustands des zwangsgeführten Relais (3, 4), wobei der Mikrocontroller (12) mit dem Öffnerkontakt (5, 6) des zwangsgeführten Relais (3, 4) verbunden ist.

9. Sicherheitsgerichtetes Schaltgerät nach dem vorhergehenden Anspruch, mit einem galvanischen Trennelement (13), wobei das galvanische Trennelement (13) zwischen dem Mikrocontroller (12) und dem Öffnerkontakt (5, 6) des zwangsgeführten Relais (3, 4) angeordnet ist.

10. Sicherheitsgerichtetes Schaltgerät, nach einem der Ansprüche 6 bis 9, wobei jedem zwangsgeführten Relais (3, 4,) jeweils ein Mikrocontroller (12) zugeordnet ist.

11. Sicherheitsgerichtetes Schaltgerät, mit einem ersten zwangsgeführten Relais (3), einer Energieversorgung (1), einer ersten Diode (8) und einem Meldeausgang (2), wobei
das erste zwangsgeführte Relais (3) einen Schaltkontakt (7) zum Schalten einer elektrischen Einrichtung aufweist,
**dadurch gekennzeichnet, dass**
das erste zwangsgeführte Relais (3) zudem einen derart ausgestalteten Öffnerkontakt (5) zum Überwachen des Schaltzustands des ersten zwangsgeführten Relais (3) aufweist, so dass der durch den Öffnerkontakt (5) überwachte Schaltzustand auf den Ausgang (2) ausgegeben wird, und
der Öffnerkontakt (5) des ersten zwangsgeführten Relais (3) und die erste Diode (8) derart in Serie zwischen der Energieversorgung (1) und dem Meldeausgang (2) geschaltet sind, dass die Kathode der ersten Diode (8) mit dem Meldeausgang (1) verbunden ist.

## Claims

1. A safety-oriented switching device, comprising a first positively driven relay (3), a power supply (1), and an output (2), wherein
the first positively driven relay (3) has a switching contact (7) for switching an electrical apparatus,
**characterised in that** the first positively driven relay (3) additionally has a normally closed contact (5) for monitoring the switched state of the first positively driven relay (3), said normally closed contact being designed such that the switched state monitored by the normally closed contact (5) is issued at the output,
the normally closed contact (5) of the first positively driven relay (3) is connected in series between the power supply (1) and the output (2), and
the output (2) is designed as a message output and as a diagnosis output.

2. The safety-oriented switching device according to the preceding claim, comprising a first diode (8), wherein the normally closed contact (5) of the first positively driven relay (3) and the first diode (8) are connected in series between the power supply (1) and the output (2) in such a way that the cathode of the first diode (8) is connected to the output (2).

3. The safety-oriented switching device according to either one of the preceding claims, comprising a second positively driven relay (4), wherein the normally closed contact (5) of the first positively driven relay (3) and the normally closed contact (4) of the second positively driven relay (4) are connected in series between the power supply (1) and the output (2).

4. The safety-oriented switching device according to either one of claims 2 or 3, comprising a first further diode (10), wherein the first further diode (10) is connected in series between the normally closed contact (5) of the first positively driven relay (3) and the first diode (8) in such a way that the anode of the first diode (8) is connected to the cathode of the first further diode (10).

5. The safety-oriented switching device according to claim 2, comprising a second positively driven relay (4) and a second diode (9), wherein the normally closed contact (6) of the second positively driven relay (4) and the second diode (9) are connected in series between the power supply (1) and the output (2) in such a way that the cathode of the second diode (9) is connected to the output (2).

6. The safety-oriented switching device according to claim 5, comprising a second further diode (11), wherein the second further diode (11) is connected in series between the normally closed contact (6) of the second positively driven relay (4) and the second diode (9) in such a way that the anode of the second diode (9) is connected to the cathode of the second further diode (11).

7. The safety-oriented switching device according to any one of the preceding claims, wherein the positively driven relay (3, 4) has just a single normally closed contact (5, 6).

8. The safety-oriented switching device according to any one of the preceding claims, comprising a microcontroller (12) for monitoring the switched state of the positively driven relay (3, 4), wherein the microcontroller (12) is connected to the normally closed contact (5, 6) of the positively driven relay (3, 4).

9. The safety-oriented switching device according to the preceding claim, comprising a galvanic separating element (13), wherein the galvanic separating element (13) is arranged between the microcontroller (12) and the normally closed contact (5, 6) of the positively driven relay (3, 4).

10. The safety-oriented switching device according to any one of claims 6 to 9, wherein each positively driven relay (3, 4) is assigned a microcontroller (12).

11. A safety-oriented switching device, comprising a first positively driven relay (3), a power supply (1), a first diode (8), and a message output (2), wherein
the first positively driven relay (3) has a switching contact (7) for switching an electrical apparatus,
**characterised in that** the first positively driven relay (3) additionally has a normally closed contact (5) for monitoring the switched state of the first positively driven relay (3), said normally closed contact being designed such that the switched state monitored by the normally closed contact (5) is issued at the output (2), and
the normally closed contact (5) of the first positively driven relay (3) and the first diode (8) are connected in series between the power supply (1) and the message output (2) in such a way that the cathode of the first diode (8) is connected to the message output (1).

## Revendications

1. Dispositif de commutation orienté vers la sécurité, avec un premier relais à guidage forcé (3), une alimentation en énergie (1) et une sortie (2), où
le premier relais à guidage forcé (3) présente un contact de commutation (7) pour la commutation d'une installation électrique,
**caractérisé en ce que**
le premier relais à guidage forcé (3) présente un contact d'ouverture (5) conçu de telle manière pour la surveillance de l'état de commutation du premier relais à guidage forcé (3) que l'état de commutation surveillé par le contact d'ouverture (5) est indiqué à la sortie (2),
le contact d'ouverture (5) du premier relais à guidage forcé (3) est branché en série entre l'alimentation en énergie (1) et la sortie (2), et
la sortie (2) est conçue sous la forme d'une sortie d'information et d'une sortie de diagnostic.

2. Dispositif de commutation orienté vers la sécurité selon la revendication précédente, avec une première diode (8), où le contact d'ouverture (5) du premier relais à guidage forcé (3) et la première diode (8) sont branchés de telle façon en série entre l'alimentation en énergie (1) et la sortie (2) que la cathode de la première diode (8) est reliée avec la sortie (2).

3. Dispositif de commutation orienté vers la sécurité selon l'une des revendications précédentes, avec un deuxième relais à guidage forcé (4), où le contact d'ouverture (5) du premier relais à guidage forcé (3) et le contact d'ouverture (4) du deuxième relais à guidage forcé (4) sont branchés en série entre l'alimentation en énergie (1) et la sortie (2).

4. Dispositif de commutation orienté vers la sécurité selon l'une des revendications 2 ou 3, avec une autre première diode (10), où l'autre première diode (10) est branchée de telle façon en série entre le contact d'ouverture (5) du premier relais à guidage forcé (3) et la première diode (8) que l'anode de la première diode (8) est reliée avec la cathode de l'autre première diode (10).

5. Dispositif de commutation orienté vers la sécurité selon la revendication 2, avec un deuxième relais à guidage forcé (4) et une deuxième diode (9), où le contact d'ouverture (6) du deuxième relais à guidage forcé (4) et la deuxième diode (9) sont branchés de telle façon en série entre l'alimentation en énergie (1) et la sortie (2) que la cathode de la deuxième diode (9) est reliée avec la sortie (2).

6. Dispositif de commutation orienté vers la sécurité selon la revendication 5, avec une autre deuxième diode (11), où l'autre deuxième diode (11) est branchée de telle façon en série entre le contact d'ouverture (6) du deuxième relais à guidage forcé (4) et la deuxième diode (9) que l'anode de la deuxième diode (9) est reliée avec la cathode de l'autre deuxième diode (11).

7. Dispositif de commutation orienté vers la sécurité selon l'une des revendications précédentes, où le relais à guidage forcé (3, 4) présente un seul contact d'ouverture (5, 6).

8. Dispositif de commutation orienté vers la sécurité selon l'une des revendications précédentes, avec un micro-dispositif de contrôle (12) pour le suivi de l'état de commutation du relais à guidage forcé (3, 4), où le micro-dispositif de contrôle (12) est relié avec le contact d'ouverture (5, 6) du relais à guidage forcé (3, 4).

9. Dispositif de commutation orienté vers la sécurité selon la revendication précédente, avec un élément de séparation galvanique (13), où l'élément de séparation galvanique (13) est disposé entre le micro-dispositif de contrôle (12) et le contact d'ouverture (5, 6) du relais à guidage forcé (3, 4).

10. Dispositif de commutation orienté vers la sécurité selon l'une des revendications 6 à 9, où chaque fois, un micro-dispositif de contrôle (12) est associé à chaque relais à guidage forcé (3, 4).

11. Dispositif de commutation orienté vers la sécurité, avec un premier relais à guidage forcé (3), une alimentation en énergie (1), une première diode (8) et une sortie d'information (2), où
le premier relais à guidage forcé (3) présente un contact de commutation (7) pour la commutation d'une installation électrique, **caractérisé en ce que**
le premier relais à guidage forcé (3) présente en outre un contact d'ouverture (5) conçu de façon à surveiller l'état de commutation du premier relais à guidage forcé (3), de sorte que l'état de commutation surveillé par le contact d'ouverture (5) est indiqué par la sortie (2), et
le contact d'ouverture (5) du premier relais à guidage forcé (3) et la première diode (8) sont branchés de telle façon en série entre l'alimentation en énergie (1) et la sortie d'informations (2) que la cathode de la première diode (8) est reliée avec la sortie d'information (1).
